(19) Europäisches Patentamt / European Patent Office / Office européen des brevets

(11) **EP 2 500 945 B1**

(12) **FASCICULE DE BREVET EUROPEEN**

(45) Date de publication et mention de la délivrance du brevet:
**02.07.2014   Bulletin 2014/27**

(51) Int Cl.:
*H01L 27/24* (2006.01)        *H01L 45/00* (2006.01)

(21) Numéro de dépôt: **12159362.8**

(22) Date de dépôt: **14.03.2012**

(54) **Cellule mémoire**

Speicherzelle

Memory cell

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:   **15.03.2011   FR 1152127**

(43) Date de publication de la demande:
**19.09.2012   Bulletin 2012/38**

(73) Titulaires:
• **Commissariat à l'Énergie Atomique et aux Énergies Alternatives**
  **75015 Paris (FR)**
• **Institut Polytechnique de Grenoble**
  **38000 Grenoble (FR)**

(72) Inventeurs:
• **Gaillardon, Pierre-Emmanuel**
  **26100 Romans (FR)**
• **Betti Beneventi, Giovanni**
  **41040 Polinago (MO) (IT)**
• **Perniola, Luca**
  **38360 Noyarey (FR)**

(74) Mandataire: **Hautier, Nicolas**
  **Cabinet Hautier**
  **20, rue de la Liberté**
  **06000 Nice (FR)**

(56) Documents cités:
WO-A2-2010/082923        FR-A1- 2 291 609
US-A1- 2003 111 679      US-A1- 2010 259 961

EP 2 500 945 B1

## Description

<u>DOMAINE TECHNIQUE DE L'INVENTION</u>

La présente invention concerne en général les mémoires non volatiles à éléments résistifs. Elle décrit plus particulièrement une cellule mémoire et son dispositif d'accès réalisables en fin de procédé de fabrication d'un composant semi-conducteur standard de type circuit intégré.

<u>ÉTAT DE LA TECHNIQUE</u>

Les mémoires à éléments résistifs utilisent un matériau qui peut basculer réversiblement entre au moins deux états stables présentant des résistances électriques différentes. Il s'agit, par exemple, des mémoires à changement de phase. Dans ce cas, on fait évoluer le matériau qui les compose entre un état amorphe et un état cristallin. L'état amorphe présente une résistivité plus élevée que l'état cristallin ce qui permet de définir au moins deux états de la cellule mémoire et donc d'y stocker au moins un bit d'information : 1 ou 0. Pour une cellule mémoire, plus on peut programmer d'états résistifs, plus on peut stocker d'information. Par exemple, si quatre états résistifs peuvent être définis d'une façon reproductible deux bits d'information peuvent être stockés par point mémoire. Ce type de cellule mémoire présente l'avantage d'être non volatile. La phase du matériau et donc l'information stockée, ne sont pas altérées par l'absence d'alimentation du circuit. C'est en effet un changement de température qui détermine le passage d'un état résistif vers un autre état résistif lors de la programmation du dispositif. En faisant circuler un courant dans le matériau à changement de phase on contrôle l'échauffement et le refroidissement de celui-ci et donc son état résistif final.

Dans le cas des mémoires à changement de phase le matériau qui permet ces changements d'états résistifs contrôlés est typiquement un chalcogénure, notamment un alliage de germanium (Ge), d'antimoine (Sb) et de tellure (Te) connu sous l'acronyme de GST et dont la composition chimique est : $Ge_2Sb_2Te_5$. Il existe d'autres types de mémoires résistives globalement désignées sous le nom de RRAM, acronyme de l'anglais « resistive random access memory », c'est-à-dire : « mémoire résistive à accès aléatoire ». Notamment, les mémoires dites «OxRAM» qui utilisent des oxydes métalliques (Ox) comme matériau dont la résistance peut être contrôlée d'une manière réversible.

Le champ d'application des mémoires résistives non volatiles couvre possiblement toutes les applications déjà couvertes par les mémoires non volatiles existantes ; notamment, les mémoires de type Flash. En raison de leur temps d'accès et de leur facilité d'écriture elles peuvent aussi remplacer les mémoires traditionnelles statiques ou SRAM, de l'anglais « static random access memory », avec l'avantage de ne pas avoir besoin d'être réinitialisées à chaque remise sous tension, par exemple, à partir d'une mémoire auxiliaire de type Flash ou d'un disque dur, comme c'est actuellement nécessaire dans de nombreuses applications.

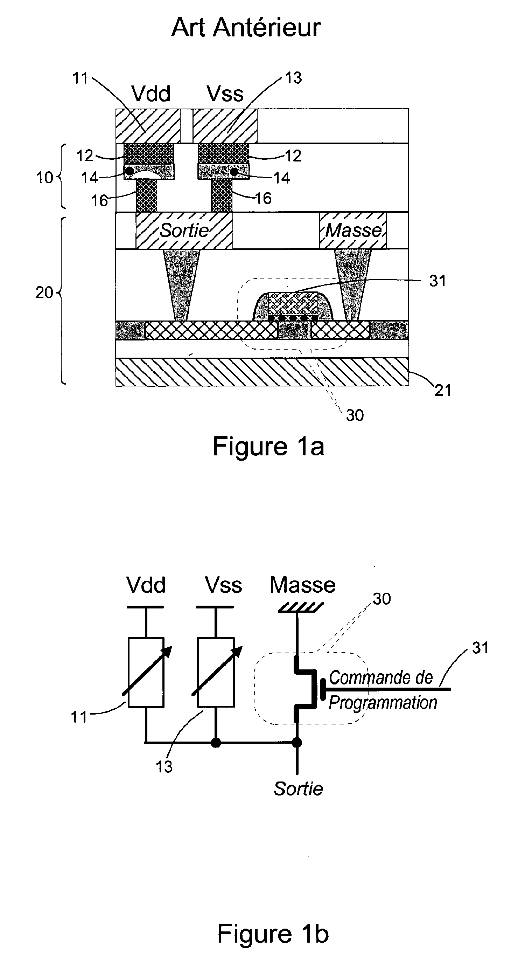

Une structure connue utilisant des éléments résistifs à changement de phase est illustrée en figures 1a et 1 b. La cellule mémoire 10 selon cet exemple comprend les deux dispositifs 11 et 13 incluant chacun une portion séparée d'un matériau à changement de phase 14. La résistivité de chacune des portions peut être réversiblement modifiée en faisant passer un courant contrôlé à travers les dispositifs 11 et 13. Les motifs 16, 16, situés sous les deux portions en matériau à changement de phase 14, 14, constituent les moyens de chauffage aptes à produire localement la chaleur nécessaire au passage du matériau à changement de phase d'un état résistif à un autre état résistif stable. Les motifs situés au dessus des deux portions en matériau à changement de phase 14, 14 sont les électrodes supérieures 12, 12 des dispositifs constituant la cellule mémoire et sont reliées à deux lignes d'alimentation, qui peuvent être reliées à deux tensions d'alimentation différentes du circuit intégré appelées ici Vdd et Vss.

La programmation de la cellule mémoire, c'est-à-dire son écriture, nécessite qu'un dispositif d'accès soit présent pour chaque cellule mémoire afin de contrôler le courant que l'on va forcer à circuler à travers l'un et l'autre des dispositifs 11 et 13 de manière à faire passer les portions du matériau à changement de phase 14, 14, d'un état résistif à un autre à l'aide des moyens de chauffage 16, 16.

D'une manière conventionnelle ce moyen d'accès est un transistor 30 qui doit alors être implanté dans les circuits sous jacents. Dans ce cas, le transistor MOS sera rendu conducteur en écriture en appliquant une tension sur sa grille de commande 31 afin, d'une part, dans cet exemple, de faire circuler le courant de programmation entre la ligne d'alimentation Vdd et la masse pour le dispositif 11, et entre la ligne d'alimentation VSS et la masse pour la programmation du dispositif 13 d'autre part.

Des autres structures connues sont divulguées par US 2010/0259961 A1, FR 2 291 609 A1, US 2003/0111679 A1 ou WO 2010/082923 A2.

Toute l'industrie de la microélectronique étant dominée par le besoin constant d'avoir à augmenter la densité d'intégration des dispositifs produits, les structures du type de celles décrites ci-dessus, employant des matériaux dont on peut faire varier l'état résistif, n'échappent pas à cette règle.

La présente invention a pour objet de répondre au moins à ce besoin.

<u>RÉSUMÉ</u>

A cet effet, selon un aspect de l'invention, on prévoit une cellule mémoire non volatile comportant au moins deux zones mémoire formée chacune dans un matériau à changement de résistivité configuré pour changer réversiblement d'état entre au moins deux états stables présentant des résistances électriques différentes, la cellule mémoire comportant au moins un moyen de chauffage associé à chaque zone mémoire, chaque moyen de chauffage présentant au moins deux extrémités dont l'une est connectée à une ligne d'alimentation et dont l'autre est mise en contact avec le matériau à changement de résistivité. De manière caractéristique, le matériau à changement de résistivité est arrangé en un bloc unique commun à chacune des zones mémoire de la cellule mémoire de sorte à créer localement chacune des zones mémoires, chacune des zones mémoires étant distincte des autres zones mémoires.

Ainsi un même bloc de matériau à changement de résistivité, commun à l'ensemble de la cellule mémoire, forme chacune des zones mémoire. L'invention permet ainsi de réduire sensiblement la taille d'une cellule mémoire. La densité de mémoire des systèmes intégrant des cellules selon l'invention peut ainsi être significativement augmentée.

En outre, et de manière avantageuse, en prévoyant de disposer un seul bloc de matériau à changement de résistivité pour l'ensemble de la cellule, l'invention permet de faciliter considérablement l'obtention de la cellule mémoire.

Avantageusement, la cellule mémoire comprend un transistor d'accès pour la programmation de la cellule mémoire. De manière particulièrement avantageuse, le transistor comprend un collecteur formé par le bloc unique de matériau à changement de résistivité. Ainsi, le matériau à changement de résistivité comprend au moins en partie un transistor d'accès pour la programmation de la cellule mémoire. Cette caractéristique permet d'augmenter considérablement la densité d'intégration des cellules mémoire.

La cellule mémoire de l'invention est donc autonome et peut être réalisée en fin de procédé d'un circuit intégré du fait, d'une part, que le collecteur du transistor d'accès est fait du matériau à changement de résistivité lui-même et, d'autre part, parce que base et émetteur sont fait d'oxydes qui peuvent être déposés à des températures suffisamment basses compatibles avec les opérations effectuées en fin de ligne de fabrication alors que les interconnexions métalliques ont déjà été formées.

Cette réalisation ne nécessite pas l'ajout dans le circuit intégré de moyens particuliers ni pour la lecture des informations stockées, ni pour la programmation de celle-ci.

Cet avantage est explicité ci-dessous par comparaison aux cellules mémoire à changement de phase connues.

Dans les cellules mémoire à changement de phase connues, comme celle illustrée en figure 1a et discutée précédemment, le type de matériau à changement de résistivité qu'il faut utiliser se prête mal à son intégration dans les étapes préliminaires du processus complexe de fabrication des circuits intégrés. En effet, avec les processus connus, basés essentiellement sur la technologie du silicium développée depuis l'origine des premiers circuits intégrés dans les années soixante, un très grand nombre des étapes préliminaires de fabrication généralement qualifiées de FEOL, de l'anglais « front end of line », c'est-à-dire celles de « de début de ligne » seraient potentiellement destructrices notamment parce qu'elles requièrent des températures très élevées pour leur mise en oeuvre. Ces étapes sont par exemple la croissance thermique d'oxyde de silicium ou la diffusion d'impuretés pour le dopage des zones semi-conductrices. Au contraire, celles qualifiées de BEOL, de l'anglais « back end of line », c'est-à-dire de « fin de ligne », qui consistent essentiellement en la formation des interconnexions entre composants s'effectue à plus basse température. Le procédé de l'invention qui s'applique après BEOL est alors compatible.

Par ailleurs il faut remarquer qu'il est souvent architecturalement très avantageux lors de la conception d'un circuit intégré de pouvoir disposer les blocs mémoires nécessaires à son fonctionnement au plus près de leur utilisation afin de limiter la longueur des interconnexions et les temps d'accès. Par exemple, les circuits logiques reprogrammables dans leur environnement communément désignés par leur acronyme de PLD (Programmable Logic Devices) et dont les plus connus sont les FPGA, de l'anglais « field programmable gate array » sont particulièrement représentatifs de cette contrainte. Typiquement, ces circuits utilisent en effet un grand nombre de tables de consultation et d'unités de routage qui définissent les interconnexions programmables entre composants. Cela prend la forme de petites mémoires statiques qui servent à personnaliser chacun des blocs logiques et leurs interconnexions afin de réaliser la fonction logique désirée. Il s'est avéré préférable que chacune des mémoires de personnalisation soit située le plus près possible du bloc logique personnalisable correspondant afin de limiter la longueur des interconnexions et obtenir de bonnes performances. Le remplacement de ces mémoires de personnalisation par des mémoires à changement de phase, non volatiles, est particulièrement avantageux car il n'est plus alors nécessaire, à chaque mise sous tension, de recharger la programmation des mémoires individuelles, c'est-à-dire les tables de consultation et les unités de routage qui définissent la logique et les interconnexions. Cette opération est longue et demande que la personnalisation soit mémorisée dans un moyen de stockage extérieur non volatile.

Il serait donc particulièrement avantageux de pouvoir réaliser des cellules mémoire à changement de phase en fin de procédé de fabrication d'un circuit intégré classique, c'est-à-dire après la dernière des étapes qui seraient susceptibles d'endommager ce type de mémoire en raison du matériau à changement de résistivité utilisé.

Il serait également particulièrement avantageux de pouvoir placer librement ces mémoires, en particulier le plus près possible des blocs logiques qui les utilisent sans avoir à introduire de contraintes spécifiques dans les blocs logiques eux-mêmes pour permettre leur utilisation effective et, notamment, pour pouvoir les sélecter en écriture.

L'invention, en prévoyant de former en partie au moins le transistor de programmation à partir du bloc unique de matériaux à changement de phase commun à toutes les zones mémoire d'une même cellule mémoire, permet d'apporter des solutions à ces objectifs additionnels. En effet, comme indiqué ci-dessus, la cellule mémoire de l'invention est donc autonome et peut être réalisée en fin de procédé d'un circuit intégré sans demander l'ajout dans ce dernier de moyens particuliers ni pour la lecture des informations stockées, ni pour la programmation de celle-ci hormis la nécessaire logique de contrôle associée, et tout en offrant une grande souplesse dans le positionnement des cellules mémoire par rapport aux blocs logiques qui les utilisent. On jouirait ainsi d'une plus grande liberté de conception et de d'utilisation des circuits intégrés.

De manière facultative, la cellule mémoire selon l'invention peut présenter au moins l'une quelconque des caractéristiques optionnelles énoncées ci-dessous.

Dans le cadre de la présente invention, le matériau à changement de résistivité est un matériau conformé pour basculer d'un état résistif stable à un autre état résistif stable, chaque état ayant une résistivité différente. Chaque état étant stable, lorsque le matériau est amené dans un état donné, il demeure dans cet état, sauf à le modifier volontairement, et présente alors la résistivité propre à cet état.

Typiquement, le passage d'un état à un autre état s'effectue en contrôlant la montée ou la descente en température du matériau à changement de résistivité.

Typiquement, le matériau à changement de résistivité peut être un matériau à changement de phase. Dans un premier état, le matériau est dans une phase amorphe. Dans un deuxième état le matériau est dans une phase cristalline. Un tel matériau présente ainsi au moins deux états résistifs stables présentant des résistivités différentes. Eventuellement dans encore un autre état le matériau est dans encore une autre phase cristalline. Il présente alors encore une autre résistivité. Selon un mode de réalisation, l'invention concerne une mémoire à changement de phase. Ce type de mémoire est habituellement désigné PCM, acronyme de l'anglais « phase change memory ».

Selon un autre mode de réalisation, l'invention concerne une mémoire résistive à accès aléatoire. Ce type de mémoire est habituellement désigné sous le nom de RRAM, acronyme de l'anglais « resistive random access memory ».

Selon un autre mode de réalisation, l'invention concerne une mémoire qui utilise des oxydes métalliques (Ox) comme matériau dont la résistance peut être contrôlée d'une manière réversible. Ce type de mémoire est habituellement désigné sous le nom de « OxRAM ».

De manière également facultative, la cellule mémoire selon l'invention présente en outre au moins l'une quelconque des caractéristiques optionnelles énoncées ci-dessous.

Le transistor est un transistor bipolaire.

Selon un mode de réalisation, le matériau à changement de résistivité est dopé pour développer une conduction de type n afin de constituer le collecteur du transistor. Le transistor comprend une base et un émetteur constitués d'oxydes métalliques respectivement dopés de type p et de type n afin de former avec le bloc unique jouant le rôle de collecteur, un transistor npn.

Selon un mode de réalisation alternatif, le matériau à changement de résistivité est dopé pour développer une conduction de type p afin de constituer le collecteur du transistor. Le transistor comprend une base et un émetteur constitués d'oxydes métalliques respectivement dopés de type n et de type p afin de former avec le bloc unique jouant le rôle de collecteur, un transistor pnp.

Selon un mode de réalisation, la base et l'émetteur sont constitués d'oxydes métalliques superposés au bloc unique de matériau à changement de résistivité jouant le rôle de collecteur. La base et l'émetteur sont par exemple déposés ou rapportés sur le collecteur. Ainsi, la base peut être rapportée ou formée directement au contact du bloc unique de matériau à changement de résistivité. L'émetteur est quant à lui de préférence rapporté ou formé directement sur le bloc unique de matériau à changement de résistivité.

Selon un mode de réalisation alternatif, la base et l'émetteur sont formés dans le bloc unique de matériau à changement de résistivité jouant le rôle de collecteur. Avantageusement, ils sont obtenus par dopages successifs des zones correspondantes du bloc unique.

Avantageusement, le bloc unique de matériau à changement de résistivité constitue une électrode de sortie pour la lecture des informations stockées dans la cellule mémoire.

Les zones mémoire sont distinctes les unes des autres. La phase de chaque zone mémoire est contrôlée de manière indépendante. Ainsi, le changement de phase d'une zone mémoire n'influence pas la phase d'une autre zone mémoire.

Une électrode de commande connectée à la base afin de faire circuler un courant depuis les lignes d'alimentation indépendantes à travers chacun des moyens de chauffage d'une part, le collecteur et l'émetteur du transistor d'autre part, de sorte à provoquer un échauffement du matériau à changement de résistivité au niveau d'au moins l'une des zones mémoires, chacune des zones mémoires étant en contact avec une extrémité des au moins deux moyens de chauffage. Ainsi, on peut provoquer un changement de phase du matériau à changement de résistivité au niveau d'au moins l'une des zones mémoires.

Avantageusement, le nombre de zones mémoires, la résistance programmée des dites zones mémoire, la tension appliquée sur chacune des lignes d'alimentation sont agencés pour que la cellule mémoire puisse délivrer des niveaux électriques, typiquement des niveaux de tension, directement lisibles par au moins un circuit électronique en contact avec la cellule mémoire ou à proximité immédiate de la cellule mémoire, typiquement un circuit électronique sous jacent.

De manière avantageuse, les zones mémoires distinctes sont programmées pour ensemble constituer au moins un pont diviseur de tension comprenant au moins une résistance de forte valeur afin de limiter la consommation en courant de la cellule mémoire et permettre de délivrer aux circuits électroniques sous jacents au moins deux niveaux électriques distincts proches des niveaux électriques appliqués sur les lignes d'alimentation indépendantes. Typiquement les niveaux électriques sont des niveaux de tension.

Avantageusement, la cellule mémoire comprend trois zones mémoires. La cellule mémoire permet ainsi de travailler en logique ternaire tout en conservant une surface limitée.

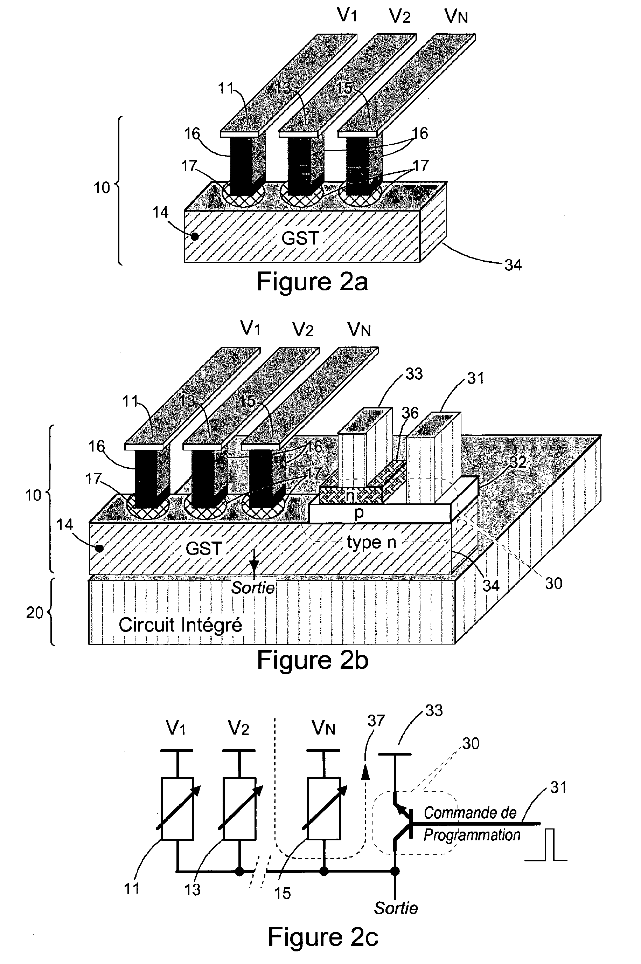

Préférentiellement, le matériau à changement de phase est choisi parmi les alliages suivants : $Ge_2Sb_2Te_5$, GeTe, GeTe dopé C, GeTe dopé N, GeSb, GaSb, InGeTe, GST dopé O. Ensuite le matériau à changement de résistivité est dopé et le type de dopage caractérisé (comme décrit en figure 2).

Les matériaux constituant la base et l'émetteur du transistor bipolaire (30) sont choisis parmi les matériaux suivants : CuO dopé p, IZO dopé n, Au-ZnO, Ag-ZnO, p-NiO-n-IZO, p-ZRO-n-ZnO, p-SCO-n-ZnO, Poly Si.

Selon un mode de réalisation privilégié, le matériau à changement de résistivité est un matériau à changement de phase. Il est conformé pour présenter une phase amorphe dans un premier état et pour présenter une phase cristalline dans au moins un deuxième état.

Selon un mode de réalisation, la cellule mémoire comprend des oxydes métalliques (Ox) dont la résistance peut être contrôlée d'une manière réversible.

Selon un mode de réalisation, le matériau à changement de résistivité est un oxyde choisi parmi les oxydes suivants : l'oxyde de cuivre (CuO), l'oxyde de silicium (SiO2), l'oxyde d'hafnium (HfO2), l'oxyde de nickel (NiO), l'oxyde de zinc (ZnO), l'oxyde d'aluminium ou alumine (Al2O3), l'oxyde de vanadium (VO2) ou encore l'oxyde de titanate de strontium (SrTiO3).

Un autre aspect de l'invention concerne un circuit intégré comprenant une pluralité de cellules mémoire selon l'une quelconque des caractéristiques précédentes.

De manière préférée, le circuit intégré comporte au moins un circuit électronique en contact avec la cellule mémoire ou à proximité immédiate de la cellule mémoire. Typiquement le circuit électronique est sous jacent à la cellule mémoire. Il est en outre configuré de sorte que ladite cellule mémoire délivre des niveaux électriques directement lisibles par l'au moins un circuit électronique sous jacent.

Préférentiellement, le nombre de zones mémoire, la résistance desdites zones mémoires et la tension appliquée sur chacune des lignes d'alimentation sont configurés pour délivrer des niveaux électriques directement lisibles par l'au moins un circuit électronique sous jacent à la cellule mémoire.

De manière également préférée, les zones mémoire sont programmées pour ensemble constituer au moins un pont diviseur de tension comprenant au moins une résistance de valeur suffisamment élevée pour permettre de délivrer à des circuits électroniques sous jacents au moins deux niveaux électriques distincts. De préférence, ces niveaux sont proches des niveaux électriques appliqués sur les lignes d'alimentation. Avantageusement, cela permet également de limiter la consommation en courant de la cellule mémoire.

Dans un mode de réalisation particulier, les cellules mémoires sont associées à des moyens d'accès configurés pour accéder de manière aléatoire aux cellules mémoires. Le circuit intégré forme ainsi une mémoire résistive à accès aléatoire (RRAM). Avantageusement, le temps d'accès est alors sensiblement le même pour chacune des cellules mémoires parmi une pluralité de cellules.

Un autre aspect de l'invention concerne un procédé de fabrication d'une cellule mémoire comprenant : une étape de formation d'un bloc unique de matériau à changement de résistivité; une étape de mise en contact du bloc unique de matériau à changement de résistivité avec au moins deux moyens de chauffage, chaque mise en contact d'un moyen de chauffage avec le matériau à changement de résistivité créant dans ce dernier une zone mémoire. Cette zone mémoire est créée au voisinage du moyen de chauffage ; une étape de connexion de chaque moyen de chauffage avec une ligne d'alimentation.

Ainsi, le procédé de fabrication de cette dernière en est significativement simplifié.

De manière facultative, le procédé selon l'invention présente en outre au moins l'une quelconque des caractéristiques énoncées ci-dessous.

Le procédé comprend une étape de réalisation d'un transistor d'accès à la cellule mémoire à partir du bloc unique de matériau à changement de résistivité.

Avantageusement, l'étape de réalisation du transistor comprend une étape consistant à former un collecteur du transistor avec le bloc unique de matériau à changement de résistivité.

De préférence, le procédé inclue une étape de formation d'une base et d'un émetteur du transistor.

Préférentiellement, les étapes de formation de la base et de l'émetteur comprennent des dépôts, à la surface du bloc unique de matériau à changement de résistivité, d'oxydes dopés.

Selon un autre mode de réalisation, la base et l'émetteur sont formés dans le bloc unique de matériau à changement de résistivité et sont obtenus successivement par dopage des zones correspondantes du bloc unique. Par exemple, la base du transistor est formée dans le bloc unique de matériau à changement de résistivité constituant le collecteur, puis de manière optionnelle et avantageuse, l'émetteur du transistor est formé dans la base. Ainsi,

Le procédé comporte des étapes de dopage effectuées de sorte à ce que le transistor soit de type npn ou pnp.

Avantageusement, toutes les étapes sont effectuées à une température qui n'est pas susceptible d'endommager les composants déjà fabriqués et en particulier les interconnexions métalliques qui sont réalisées en fin de ligne, à des étapes du processus de fabrication généralement qualifiées de BEOL, comme discuté précédemment. Cette température est en tout état de cause inférieure à la plus basse des températures utilisées en fin de ligne Typiquement, toutes les étapes sont effectuées à une température inférieure ou égale à 450 °C et de préférence inférieure ou égale à 400 °C. Ainsi l'ensemble des étapes est effectué à basse température, on qualifie de basse température une température inférieure à 400 °C.

De manière également avantageuse, toutes les étapes sont effectuées à l'issue de la réalisation d'au moins un circuit électronique sous-jacent.

Les étapes sont ainsi réalisées à basse température sans inconvénients pour le circuit sous jacent et ses interconnexions.

Les autres objets, caractéristiques et avantages de la présente invention apparaîtront à l'examen de la description suivante et des dessins d'accompagnement. Il est entendu que d'autres avantages peuvent être incorporés.

<u>BRÈVE DESCRIPTION DES FIGURES</u>

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1a décrit pour comparaison une mise en oeuvre d'une cellule mémoire connue à changement de phase effectuée en fin de processus de fabrication d'un circuit intégré classique.

La FIGURE 1b est un schéma électrique de la cellule mémoire illustrée en figure 1a.

La FIGURE 2a décrit la structure d'une portion de cellule mémoire selon un exemple de réalisation de l'invention.

La FIGURE 2b décrit la structure d'une cellule mémoire autonome à changement de phase selon un premier exemple de réalisation de l'invention qui inclut son propre dispositif d'accès pour la programmation de la cellule et qui peut être entièrement réalisé en fin de processus de fabrication d'un circuit intégré classique.

La FIGURE 2c est un schéma électrique de la cellule mémoire illustrée en figure 2b.

La FIGURE 3a décrit un deuxième exemple de réalisation d'une cellule mémoire autonome à changement de phase selon l'invention.

La FIGURE 3b est un schéma électrique de la cellule mémoire illustrée en figure 3a.

La FIGURE 4 décrit un troisième exemple de réalisation d'une cellule mémoire autonome à changement de phase selon l'invention.

La FIGURE 5a montre une mémoire résistive de type OxRAM.

Les FIGURES 5b et 5c illustrent deux modes de fonctionnement différents des mémoires de type OxRAM.

La FIGURE 6 illustre la réalisation d'un exemple de cellule mémoire de type OxRAM correspondant à une structure de cellule mémoire de l'invention.

Les dessins joints sont donnés à titre d'exemples et ne sont pas limitatifs de l'invention.

<u>DESCRIPTION DÉTAILLÉE DE L'INVENTION</u>

Les figures 1a et **1b** décrivent pour comparaison une mise en oeuvre connue d'une cellule mémoire à changement de phase 10 effectuée en fin de processus de fabrication d'un circuit intégré classique 20. La figure 1a est une vue en coupe de la cellule mémoire et la figure 1b est le schéma électrique correspondant.

Dans ce type de mise en oeuvre le circuit intégré est traditionnellement réalisé à partir d'un substrat en silicium 21 et comprend un plus ou moins grand nombre de couches superficielles qui peuvent être formées optionnellement par des moyens très variés utilisés d'une façon standard par l'industrie de la microélectronique. Ces moyens incluent entre autres l'épitaxie, la diffusion à haute température de dopants, l'oxydation thermique du silicium, le dépôt de matériaux divers, en particulier le métal servant aux interconnexions, et l'implantation par bombardement ionique de produits dopants du silicium. Dans ces couches, des motifs sont définis à chaque étape par lithographie pour former tous les composants du circuit intégré. Les composants sont typiquement des transistors à effet de champs de type métal-oxyde-semiconducteur (MOS). Le plus souvent deux types de transistors MOS complémentaires sont réalisés simultanément, l'un dont le canal est de type n et l'autre dont le canal est de type p, conduisant à la technologie dite CMOS très utilisée par l'industrie de la microélectronique pour la réalisation des circuits intégrés les plus complexes et les plus performants.

La cellule mémoire 10, qui est réalisée en fin de processus de fabrication du circuit intégré, et donc par-dessus les couches correspondantes 20, comprend dans cet exemple les deux dispositifs 11 et 13 incluant chacun une portion d'un matériau à changement de résistivité 14, 14. La résistivité de chacun des portions peut être réversiblement modifiée en faisant passer un courant contrôlé à travers les dispositifs 11 et 13. Les motifs 16, 16, situés sous les deux portions en matériau à changement de résistivité 14, 14, constituent les moyens de chauffage aptes à produire localement la chaleur nécessaire au passage du matériau à changement de résistivité d'un état résistif à un autre état résistif. Les moyens de chauffage sont également désignés éléments chauffants. Les motifs situés au dessus des deux portions en matériau à changement de résistivité 14, 14 sont les électrodes supérieures 12 des dispositifs constituant la cellule mémoire et sont reliées à deux lignes d'alimentation différentes, qui pourront être reliées à deux tensions différentes du circuit intégré appelées ici Vdd et Vss.

La programmation de la cellule mémoire, c'est-à-dire son écriture, nécessite qu'un dispositif d'accès soit présent pour chaque cellule mémoire, afin de contrôler le courant que l'on va forcer à circuler à travers l'un et l'autre des dispositifs 11 et 13 de manière à de faire passer les portions du matériau à changement de résistivité 14, 14, d'un état résistif à un autre état résistif, à l'aide des moyens de chauffage 16, 16.

D'une manière conventionnelle ce moyen d'accès est un transistor 30 qui doit alors être implanté dans les circuits sous jacents. Transistor MOS dans ce cas qui sera rendu conducteur en écriture en appliquant une tension sur sa grille de commande 31 afin, d'une part, de faire circuler le courant de programmation entre la ligne d'alimentation Vdd et la masse pour le dispositif 11, et entre la ligne d'alimentation Vss et la masse pour la programmation du dispositif 13 d'autre part.

Dans ce mode de réalisation conventionnel, en ce qui concerne l'écriture, chaque cellule mémoire reste ainsi dépendante des circuits sous-jacents dans lesquels il faut prévoir d'implanter autant de dispositifs d'accès qu'il y a de cellules mémoires à changement de phase utilisées.

La **figure 2** décrit la structure d'une cellule mémoire à changement de phase selon l'invention et qui répond à ce problème. La figure 2a est une vue en coupe des éléments de mémorisation. La figure 2b montre comment, dans une première mise en oeuvre de l'invention, le dispositif d'accès en écriture et les éléments de mémorisation sont imbriqués pour former une cellule mémoire autonome. La figure 2c est le schéma électrique correspondant.

Comme montré sur la figure 2a le matériau à changement de résistivité 14, typiquement du GST, forme cette fois un bloc unique 34 commun qui peut alors être partagé entre tous les éléments à résistance variable d'une cellule mémoire 10 permettant d'augmenter la densité d'intégration. Ce partage permet aussi de ne pas limiter à deux le nombre de ces éléments comme cela était le cas en figure 1. A titre d'exemple, trois dispositifs : 11, 13 et 15 sont représentés qui permettent de définir plus de deux états et ainsi d'augmenter la capacité de stockage de la cellule mémoire au prix d'une faible augmentation de sa surface. Il y a autant de moyens de chauffage 16 que de dispositifs. Ils permettent de définir dans le bloc unique commun 34 des zones indépendantes 17 où la résistance du matériau pourra être contrôlée individuellement. Les dispositifs sont alors alimentés chacun par une tension d'alimentation spécifique $V_1, V_2, \ldots, V_N$.

La formation du bloc 34 de matériau à changement de résistivité 14 n'est pas limitée à l'emploi de GST mentionné dans le chapitre sur l'état de la technique. D'autres alliages tels que : GeTe, GeTe dopé C, GeTe dopé N, GeSb, GaSb, InGeTe, GST dopé O et GST dopé N peuvent avantageusement être utilisés. Les matériaux composants les alliages ci-dessus et leurs dopants sont désignés à l'aide de leur symbole chimique normalisé respectif. C'est-à-dire, dans l'ordre où ils sont cités : le germanium (Ge), le tellure (Te), le carbone (C), l'azote (N), l'antimoine (Sb), le gallium (Ga), l'indium (In) et l'oxygène (O).

Le rôle des dopants et de conférer aux alliages cités des propriétés favorables à leur emploi comme élément mémoire résistif : facilité de programmation d'un état résistif, rétention de cet état résistif au cours des cycles de lecture successifs et raccourcissement des temps de lecture et d'écriture.

Comme montré sur la figure 2b l'invention résout le problème de la sélection de la cellule mémoire pour sa programmation en intégrant le moyen d'accès à partir du bloc 34 de matériau à changement de résistivité 14 lui-même afin de la rendre autonome.

Selon le mode d'élaboration utilisé, le GST ou le matériau à changement de résistivité choisi, peut être considéré comme initialement dopé même si aucun dopant n'a été ajouté lors de son élaboration. Le matériau à changement de résistivité est formé, par exemple, par dépôt chimique ou physique en phase vapeur. Le dopage apparent provient alors du procédé de dépôt utilisé. Le dopage peut également provenir de l'apport d'un dopant spécifique, typiquement sous forme gazeuse lors du dépôt. Quel que soit le mode d'élaboration retenu pour la formation du matériau à changement de résistivité 14 l'invention demande que celui-ci soit dopé, dans cette première mise en oeuvre de l'invention, afin de développer un type de conduction par excès d'électrons c'est-à-dire de type n. Le bloc 34 va pouvoir ainsi constituer le collecteur d'un transistor bipolaire à jonction de type npn 30. Transistor qui, comme discuté ci-dessus, va pouvoir servir de dispositif d'accès pour la programmation de la cellule mémoire sans avoir besoin de recourir aux composants du circuit intégré sous jacent comme décrit en figure 1.

Dans cette première mise en oeuvre la base 32 du transistor est formée par dépôt d'une couche d'un matériau dopé de type p afin de développer une conduction par trous ou carence d'électrons. C'est par exemple un oxyde de cuivre (CuO dopé p) qui constitue une première hétérojonction avec le GST du collecteur.

L'émetteur 36 du transistor est déposé sur la base 32 pour former une couche d'un matériau dopé de type n. Il s'agit à nouveau d'un oxyde, par exemple celui d'un alliage d'indium et de zinc (IZO dopé n) qui va constituer la seconde hétérojonction du transistor bipolaire 30.

Le transistor de type npn d'accès à la cellule mémoire est ainsi fait de GST, ou d'un matériau à changement à phase, et d'oxydes dopés. Les étapes de formation du transistor d'accès et celles pour la formation de la cellule mémoire en général se font toutes à partir de dépôts des matériaux correspondants à des températures dites basses qui n'excèdent pas 450°C voire 400°C. Ce qui est compatible avec le processus de fabrication du circuit intégré sous jacent et ne risque pas d'en endommager les composants, et notamment les lignes d'interconnexions métalliques déjà formées.

La formation du transistor n'est pas limitée à l'emploi des oxydes mentionnés ci-dessus. D'autres oxydes et matériaux peuvent avantageusement être utilisés pour la base et l'émetteur, tels que : Au-ZnO, Ag-ZnO, NiO-IZO, ZRO-ZnO, SCO-ZnO, Poly Si, afin de former à basse température des hétérojonctions de type pn ou Schottky, c'est-à-dire métal-semiconducteur. Les oxydes et matériaux ci-dessus sont désignés à l'aide de leur symbole chimique normalisé respectif. C'est-à-dire, dans l'ordre où ils sont cités : l'or (Au), l'oxyde de zinc (ZnO), l'argent (Ag), l'oxyde de nickel (NiO), l'oxyde d'un alliage d'indium et de zinc (IZO).

Les techniques de dopage des matériaux utilisés incluent la déposition en phase vapeur et l'implantation ionique. La déposition en phase vapeur permet qu'un dopage in situ puisse se pratiquer auquel cas la couche dopée peut être construite aussi bien au dessus qu'en dessous de la couche intrinsèque (non dopée). Il est cependant difficile de contrôler les concentrations de dopants et leurs profiles. Le processus de dopage requiert une caractérisation comme notamment celle mentionnée ci-après qui permet d'appliquer les corrections nécessaires après coup. L'implantation ionique permet au contraire un bon contrôle des concentrations de dopants et de leurs profiles.

Par ailleurs, si la température de recuit nécessaire pour activer les dopants est trop élevée au regard du budget thermique permis pour les opérations du processus de fabrication effectuées en fin de ligne (<400 °C) on peut avoir recours à des techniques d'implantation à fort courant ionique ne requerrant cependant que de très faible énergies afin d'éviter le recuit à haute température. Techniques qui ont été décrites par exemple dans MSIB system, par K. Yamamoto, Surface Science 600, 2006, 3753-3756.

Un matériau utilisé comme dopant des matériaux à changement de phase est par exemple l'oxygène (O). À ce sujet on pourra se reporter à K. B. Song, dans "Applied Physic Letters (APL)", 93, 043514, 2008. Le zinc (Zn) et le gallium (Ga) sont aussi des dopants de type n de matériaux à changement de phase tels que : le zinc sélénide (ZnSe), le zinc sulfide (ZnS), ou leur association ZnS/ZnSe. À ce propos on pourra se reporter à Kun et al. dans US3,670,220.

Le type de conductivité du matériau à changement de résistivité utilisé peut être déterminé par différentes méthodes de caractérisation qui incluent :

- Des mesures basées sur l'effet Hall.
- Des expérimentations thermo électriques exploitant l'effet Seebeck.
- Des méthodes de rectification.
- Des techniques optiques développant des tensions de surface.

Le dopage équivalent du matériau à changement de résistivité intrinsèque peut aussi être déterminé par des mesures de capacité en fonction de la tension (CV).

La mise au point du processus de dopage peut alors être réalisée sur la base des résultats ci-dessus en utilisant la théorie bien connue des jonctions pn. La permittivité électrique peut être simplement déduite des mesures effectuées sur une capacité formant un empilement ou sandwich dont le matériau à changement de résistivité dopé constitue l'isolant.

D'une façon générale toutes les techniques d'expérimentation de type « essais et erreurs », par approximations successives, peuvent être utilisées pour déterminer les doses appropriées de dopage.

Les détails sur ces méthodes de caractérisation peuvent être trouvées dans « D. K. Schroder, "Semiconductor materials and device characterization, 3rd ed. IEEE press, 2006 »

Enfin, comme déjà discuté précédemment, on peut voir dans la figure 2b que le dispositif d'accès 30, fait maintenant partie intégrante de la cellule mémoire 10. Il va permettre de contrôler le courant 37 que l'on va forcer à circuler à travers les dispositifs 11, 13 et 15 afin de faire passer le matériau 14, d'un état résistif à un autre état résistif au cours de la programmation de la cellule mémoire. Le passage du matériau à changement de résistivité d'un état résistif à un autre état résistif se fait localement 17, au droit de chacun des moyens de chauffages 16, qui sont reliés directement aux lignes d'alimentation $V_1$, $V_2$ et $V_N$ dans cette nouvelle structure. Le courant de programmation circule ainsi entre les lignes d'alimentation et l'émetteur 36 du transistor bipolaire qui est lui-même relié à une tension basse 33, par exemple la masse du dispositif. Bénéficiant de l'amplification du transistor, un faible courant de commande 31 injecté dans la base 32 permet d'obtenir ce résultat.

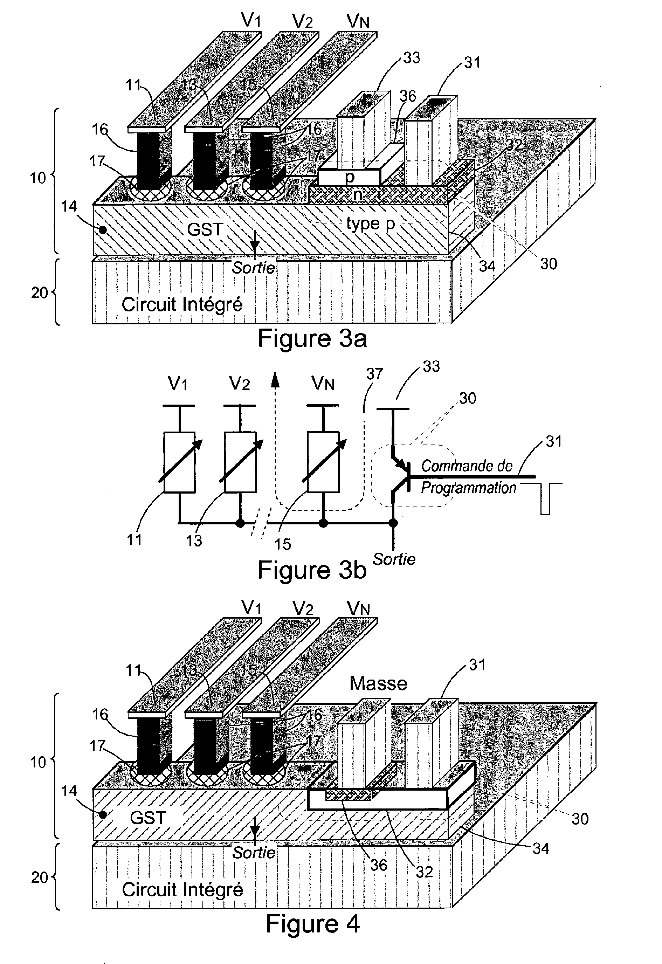

La figure 3 qui est composée des figures 3a et 3b, décrit une deuxième mise en oeuvre de l'invention dans laquelle le dispositif d'accès est cette fois un transistor 30 de type pnp.

Le processus d'élaboration des zones mémoires et du transistor d'accès est globalement le même que celui décrit dans la figure 2. Afin de pouvoir former un transistor pnp (au lieu d'un transistor npn) le bloc unique 34 de matériau à changement de résistivité 14 doit maintenant avoir été initialement élaboré, ou doit être dopé, pour développer un mode de conduction de type p, c'est-à-dire un mode de conduction par carence d'électrons afin de constituer aussi, comme précédemment, le collecteur du transistor 30. La base 32 et l'émetteur 36 sont aussi des oxydes déposés qui peuvent être choisis parmi les matériaux cités dans la description de la figure 2. Par exemple, un oxyde de cuivre (CuO dopé p) peut cette fois constituer l'émetteur 36 tandis qu'un oxyde d'un alliage d'indium et de zinc (IZO dopé n) constituera la base.

La figure 3b représente le schéma électrique de la cellule décrite ci-dessus. Le transistor étant de type opposé au cas précédent le courant 37 de programmation des résistances va circuler depuis un niveau électrique 33 plus élevé que celui des lignes d'alimentation V1, V2 et VN

La figure 4 illustre une troisième mise en oeuvre de l'invention dans laquelle la base 32 et l'émetteur 36 ne sont pas obtenus par des dépôts successifs d'oxydes comme décrit précédemment mais résultent de dopages successifs des zones correspondantes du bloc 34 de matériau à changement de résistivité 14 utilisé. Comme dans les cas précédents, en fonction des dopages respectifs des zones collecteur, base et émetteur les deux types de transistors bipolaires, c'est-à-dire : npn et pnp, pourront être produits qui correspondent aux schémas électriques des figures 2c et 3b respectivement.

Le dopage du bloc unique 34 permettant d'obtenir la structure de transistor 30 illustrée par la figure 4 est typiquement réalisée par des dépôts physiques en phase vapeur ou par des implantations ionique successifs de dopants dans le bloc 34. Comme déjà mentionné dans la description de la figure 2 le contrôle des niveaux de dopage peut être réalisé plus aisément par implantation ionique. Toutefois, la mise en oeuvre des techniques de caractérisation du dopage obtenu, décrites également en figure 2, permet aussi l'emploi de dépôts physiques en phase vapeur. De plus, comme décrit, des recuits à basse température peuvent être également pratiqués.

Les matériaux utilisés pour doper le bloc 34 de matériau à changement de phase sont ceux déjà mentionnés dans la description de la figure 2. Il s'agit donc notamment de l'oxygène (O), du zinc (Zn), du gallium (Ga), du zinc sélénide (ZnSe), du zinc sulfide (ZnS), ou de leur association ZnS/ZnSe.

Quel que soit le mode de mise en oeuvre de l'invention l'électrode de sortie de la cellule mémoire est constituée du bloc 34 de matériau à changement de résistivité 14. On remarquera que dans cette structure, inversée par rapport à celle de la figure 1, la sortie de la cellule mémoire est directement accessible depuis les composants du circuit intégré 20 sous jacent. Les cellules mémoires peuvent donc être placées au plus près de leur utilisation et ne nécessitent l'ajout d'aucun composant de sélection dans le circuit intégré répondant ainsi aux objectifs de l'invention.

En outre, les cellules mémoires à changement de phase 10 sont ainsi réalisées en fin de processus de fabrication du circuit intégré 20 sous jacent et à des températures qui n'excèdent pas 400 °C. L'invention permet ainsi de simplifier significativement les procédés d'obtention des circuits intégrés incorporant des cellules mémoires.

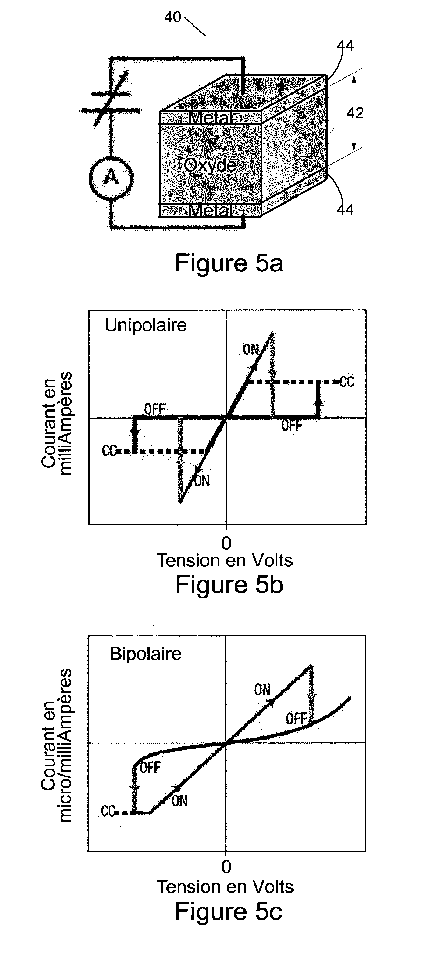

Comme indiqué précédemment, l'invention peut être appliquée aux mémoires résistives de type OxRAM. La figure 5, qui comprend les figures 5a à 5c, décrit brièvement le fonctionnement des mémoires résistives de type OxRAM mentionnées précédemment. La figure 5a montre la structure d'une telle mémoire 40 qui est faite d'un oxyde 42 entre deux électrodes 44 métalliques constituant une structure dite MIM c'est-à-dire : métal-isolant-métal.

Les mémoires OxRAMs fonctionnent selon deux modes distincts dépendant des matériaux utilisés. Le comportement peut être unipolaire ou bipolaire comme montré, respectivement, dans les figures 5b et 5c. La résistance de commutation d'un élément mémoire OxRAM correspond à un changement brusque entre un état hautement résistant noté OFF et un état faiblement résistant noté ON. Le changement de résistance est obtenu en appliquant une tension V supérieure à une tension de seuil $V_T$.

Après électro-formation, qui correspond à la commutation de résistance induite par la tension depuis un état hautement résistant vers un état conducteur du film tel que déposé, l'application de tensions de balayage unipolaires ou bipolaires permet de produire des changements de résistance réversibles dans la capacité MIM conduisant à l'obtention de courbes I-V, c'est à dire de courbes courant-tension, qui présentent des caractéristiques d'hystérésis.

La commutation est dite non polaire ou unipolaire quand la procédure de commutation ne dépend pas de la polarité des signaux de tension et de courant. Un système dans son état hautement résistant (OFF) est commuté (réinitialisé) par une tension de seuil dans l'état faiblement résistant (ON) comme montré sur la figure 5b. Le courant est limité par le courant de conformité du circuit de contrôle. Le retour à l'état OFF se produit à un courant plus élevé et pour une tension plus basse que la tension de réinitialisation.

Au contraire, la caractéristique est appelée bipolaire ou anti symétrique quand la réinitialisation dans l'état ON se produit pour une polarité de tension et le retour à l'état OFF pour la polarité de tension inverse comme montré sur la figure 5c. La structure du système doit présenter une certaine asymétrie, comme par exemple des matériaux d'électrodes différents, ou la polarité de la tension dans l'étape d'électro-formation, afin que le comportement de commutation bipolaire puisse être observé. Pour les deux caractéristiques, unipolaire et bipolaire, la lecture de l'état est faite à des tensions faibles qui ne doivent pas affecter cet état.

La différence majeure entre ces deux types de mémoires tient dans la façon de les programmer. Dans le cadre de l'invention, les mémoires sont programmées par une unité de programmation adaptée pour délivrer les signaux de programmation adéquats pour la technologie. Le fonctionnement en régime statique du point mémoire étant basé sur les états résistifs, celui-ci n'est pas modifié mais reste soumis à des tensions inférieures au seuil de basculement des mémoires. Dans le cas d'une mémoire unipolaire le seuil est de l'ordre de 0,6 Volt tandis que dans le cas d'une mémoire bipolaire le seuil est supérieur à 2 Volts. La mémoire bipolaire laisse donc plus de marge de manoeuvre. Les mémoires bipolaires comme unipolaires sont compatibles avec la mise en oeuvre de l'invention.

Comme illustré dans les figures 2a à 3b l'invention prévoit la possibilité de créer un point logique ternaire. La mise en place de logique ternaire nécessite bien entendu l'utilisation de dispositifs fonctionnant eux-mêmes en logique ternaire ce qui implique que si la sortie du point mémoire est en trois états, l'entrée de la cellule logique sous-jacente doit également l'être. L'émergence de nouvelles technologies comme celle des transistors à nanotubes de carbone où il faut pouvoir appliquer trois niveaux électriques sur leur grille arrière, par exemple -1 Volt, 0 Volt et 1 Volt, ouvre la porte à de telles applications de l'invention.

Le fonctionnement du point en logique ternaire est le suivant : une mémoire sur les trois est programmée pour être conductrice et présenter une faible résistance Ron, tandis que les deux autres sont maintenues à une résistance élevée Roff. Il en résulte un diviseur de tension de la même façon que dans le cas binaire. La valeur de l'état en sortie, dans le cas ou la mémoire en basse résistivité est reliée au potentiel V1 est la suivante :

$$Vout = \frac{\dfrac{V1}{Ron} + \dfrac{V2}{Roff} + \dfrac{V3}{Roff}}{\dfrac{1}{Ron} + \dfrac{2}{Roff}} \approx V1$$

Ceci peut être étendu à d'autre cas de logique n-aire. Il suffit d'ajouter une mémoire et un niveau logique différent sur le rail d'alimentation associé.

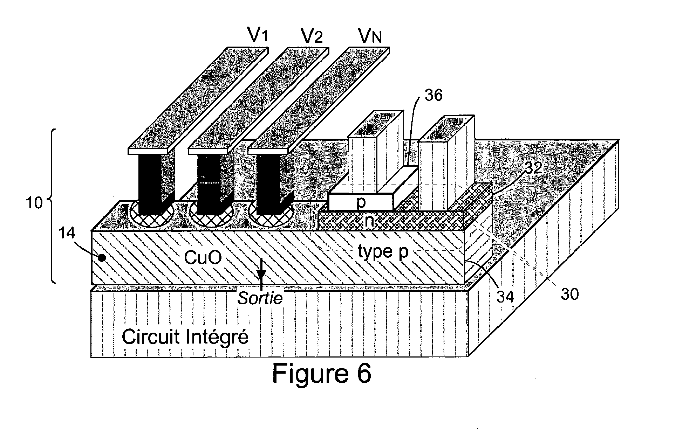

La figure 6 illustre la réalisation d'une cellule mémoire de type OxRAM correspondant à la structure de cellule de l'invention décrite précédemment dans les figures 2 et 3. Dans cette mise en oeuvre de l'invention le bloc unique 34, constituant le collecteur du transistor bipolaire 30, est donc cette fois non plus constitué d'un matériau 14 à changement de phase mais d'un oxyde.

Comme déjà mentionné, l'oxyde de cuivre (CuO) qui développe une conduction de type p, et l'oxyde de l'alliage d'indium et de zinc (IZO) qui développe une conduction de type n, seront avantageusement utilisés pour réaliser la cellule mémoire illustrée par la figure 6. La cellule 10 présente alors un bloc unique 34 formant le collecteur réalisé en oxyde de cuivre de CuO. La base 32 et l'émetteur 34 du transistor bipolaire sont constitués, respectivement, d'IZO et de CuO réalisant ainsi un transistor pnp. Le schéma électrique de la cellule illustrée par la figure 6 est donc le même que celui décrit en figure3b.

La réalisation d'une cellule mémoire OxRAM conforme à la figure 6 peut être étendue à l'emploi de tout matériau compatible incluant les oxydes suivant qui s'avèrent particulièrement avantageux: l'oxyde de silicium (SiO2), l'oxyde d'hafnium (HfO2), l'oxyde de nickel (NiO), l'oxyde de zinc (ZnO), l'oxyde d'aluminium ou alumine (Al2O3), l'oxyde de vanadium (VO2) ou encore l'oxyde de titanate de strontium (SrTiO3).

L'invention n'est pas limitée aux modes de réalisation précédemment décrits mais s'étend à tout mode de réalisation conforme aux revendications.

**Revendications**

1. Cellule mémoire (10) non volatile comportant au moins deux zones mémoire (17) distinctes et formée chacune dans un matériau à changement de résistivité (14) apte à changer réversiblement d'état entre au moins deux états stables présentant des résistances électriques différentes, la cellule mémoire (10) comportant au moins un moyen de chauffage (16) pour chaque zone mémoire (17), chaque moyen de chauffage (16) présentant au moins deux extrémités dont l'une est connectée à une ligne d'alimentation (V1, V2, .., VN) et dont l'autre est mise en contact avec le matériau à changement de résistivité (14), le matériau à changement de résistivité (14) étant arrangé en un bloc unique (34) commun à chacune des zones mémoire (17) de la cellule mémoire (10) de sorte à créer localement chacune des zones mémoires (17) distinctes, **caractérisée en ce que** la cellule mémoire (10) comprend un transistor (30) d'accès pour la programmation de la cellule mémoire (10), le transistor (30) comprenant un collecteur formé par le bloc unique (34) de matériau à changement de résistivité (14).

2. Cellule mémoire (10) selon la revendication précédente dans laquelle le transistor (30) comprend une base (32) et un émetteur (36) constitués d'oxydes métalliques superposés au bloc unique (34) de matériau à changement de résistivité (14).

3. Cellule mémoire (10) selon la revendication précédente dans laquelle les matériaux constituant la base (32) et l'émetteur du transistor (30) sont choisis parmi les oxydes suivants : CuO dopé p, IZO dopé n, Au-ZnO, Ag-ZnO, NiO-IZO, ZRO-ZnO, SCO-ZnO, Poly Si.

4. Cellule mémoire (10) selon la revendication 1 dans laquelle le transistor comprend une base (32) et un émetteur (36), et dans laquelle la base (32) et l'émetteur (36) sont formés dans le bloc unique (34) de matériau à changement de résistivité (14).

5. Cellule mémoire (10) selon l'une quelconque des revendications précédentes dans laquelle le bloc unique (34) de matériau à changement de résistivité (14) constitue une électrode de sortie pour la lecture des informations stockées dans la cellule mémoire (10).

6. Cellule mémoire (10) selon l'une quelconque des revendications précédentes dans laquelle le matériau à changement de résistivité (14) est conformé pour présenter une phase amorphe dans un premier état et pour présenter une phase cristalline dans au moins un deuxième état et dans laquelle le matériau à changement de résistivité (14) est de préférence choisi parmi les alliages suivants : Ge2Sb2Te5, GeTe, GeTe dopé C, GeTe dopé N, GeSb, GaSb, InGeTe, GST dopé O.

7. Cellule mémoire (10) selon l'une quelconque des revendications 1 à 5 dans laquelle le matériau à changement de résistivité (14) est un oxyde choisi parmi les oxydes suivants : l'oxyde de cuivre (CuO), l'oxyde de silicium (SiO2), l'oxyde d'hafnium (Hf02), l'oxyde de nickel (NiO), l'oxyde de zinc (ZnO), l'oxyde d'aluminium ou alumine (Al2O3), l'oxyde de vanadium (VO2) ou encore l'oxyde de titanate de strontium (SrTi03).

8. Cellule mémoire (10) selon l'une quelconque des revendications précédentes comprenant au moins trois zones mémoires (17).

9. Circuit intégré comprenant une pluralité de cellules mémoires (10) selon l'une quelconque des revendications précédentes.

10. Circuit intégré selon la revendication précédente comportant au moins un circuit électronique sous jacent (20) à une cellule mémoire (10) et configuré de sorte que ladite cellule mémoire (10) délivre des niveaux électriques directement lisibles par l'au moins un circuit électronique sous jacent (20) et dans lequel le nombre de zones mémoire (17), la résistance desdites zones mémoires et la tension appliquée sur chacune des lignes d'alimentation (V1, V2,.., VN) sont de préférence configurés pour délivrer des niveaux électriques directement lisibles par l'au moins un circuit électronique sous jacent (20) à la cellule mémoire (10).

11. Circuit intégré selon l'une quelconque des deux revendications précédentes dans lequel les zones mémoire (17) sont programmées pour ensemble constituer au moins un pont diviseur de tension comprenant au moins une résistance dont la valeur est suffisamment élevée pour délivrer à des circuits électroniques sous jacents (20) au moins deux niveaux de tension distincts proches des tensions électriques appliquées sur les lignes d'alimentation indépendantes (V1, V2,.., VN).

12. Procédé de fabrication d'une cellule mémoire (10) selon l'une quelconque des revendications 1 à 7 ou d'un circuit intégré selon l'une quelconque des revendications 8 à 11, comprenant :

   - une étape de formation d'un bloc unique (34) de matériau à changement de résistivité (14) ;
   - une étape de mise en contact du bloc unique (34) de matériau à changement de résistivité (14) avec au moins deux moyens de chauffage (16),
   - une étape de connexion de chaque moyen de chauffage (16) avec une ligne d'alimentation (V1, V2,.., VN),
   **caractérisé en ce qu'**il comprend :
   - une étape de réalisation d'un transistor (30) d'accès à la cellule mémoire (10), l'étape de réalisation du transistor (30) comprenant une étape consistant à former un collecteur du transistor (30) avec le bloc unique (34) de matériau à changement de résistivité (14).

13. Procédé selon la revendication précédente comprenant des étapes de formation d'une base (32) et d'un émetteur (36) du transistor (30), les étapes de formation de la base (32) et de l'émetteur (36) comprenant des dépôts d'oxydes dopés successivement depuis la surface du bloc unique (34) de matériau à changement de résistivité.

14. Procédé selon la revendication 12 comprenant des étapes de formation d'une base (32) et d'un émetteur (36) du transistor (30), dans lesquelles la base (32) et l'émetteur (36) sont formés dans le bloc unique (34) de matériau à changement de résistivité et sont obtenus successivement par dopage de zones du bloc unique (34).

15. Procédé selon l'une quelconque des trois revendications précédentes dans lequel les étapes sont effectuées à une température inférieure à 450 °C et sont de préférence effectuées à l'issue de la réalisation d'au moins un circuit électronique sous-jacent (20) à la cellule mémoire (10).

**Patentansprüche**

1. Nicht-flüchtige Speicherzelle (10), aufweisend wenigstens zwei getrennte Speicherzonen (17), die jeweils in einem Widerstandsänderungsmaterial (14) gebildet ist, das einen Zustand zwischen wenigstens zwei stabilen Zuständen mit unterschiedlichen elektrischen Widerständen reversibel ändern kann, wobei die Speicherzelle (10) wenigstens eine Heizeinrichtung (16) für jede Speicherzone (17) aufweist, wobei jede Heizeinrichtung (16) wenigstens zwei Enden aufweist, von denen eines mit einer Versorgungsleitung (V1, V2, .., VN) verbunden ist und das andere mit dem Widerstandsänderungsmaterial (14) in Kontakt steht, wobei das Widerstandsänderungsmaterial (14) gemeinsam mit jeder Speicherzone (17) der Speicherzelle (10) in einem Einheitsblock (34) derart angeordnet ist, dass jede der getrennten Speicherzonen (17) lokal erzeugt wird, **dadurch gekennzeichnet, dass** die Speicherzelle (10) einen Zugangstransistor (30) für die Programmierung der Speicherzelle (10) aufweist, wobei der Transistor (30) einen Kollektor aufweist, der aus dem Einheitsblock (34) des Widerstandsänderungsmaterials (14) gebildet ist.

2. Speicherzelle (10) nach dem vorhergehenden Anspruch, bei welcher der Transistor (30) eine Basis (32) und einen Emitter (36) aufweist, die aus Metalloxiden bestehen, die auf dem Einheitsblock (34) des Widerstandsänderungsmaterials (14) aufliegen.

3. Speicherzelle (10) nach dem vorhergehenden Anspruch, bei welchem die Materialien, die die Basis (32) und den Emitter des Transistors (30) bilden, ausgewählt sind aus den folgenden Oxiden: p-dotiertes CuO, n-dotiertes IZO, Au-ZnO, Ag-ZnO, NiO-IZO, ZRO-ZnO, SCO-ZnO, Poly-Si.

4. Speicherzelle (10) nach Anspruch 1, bei welcher der Transistor eine Basis (32) und einen Emitter (36) aufweist, und bei welcher die Basis (32) und der Emitter (36) in dem Einheitsblock (34) des Widerstandsänderungsmaterials (14) gebildet sind.

5. Speicherzelle (10) nach einem der vorhergehenden Ansprüche, bei welcher der Einheitsblock (34) des Widerstandsänderungsmaterials (14) eine Ausgangselektrode zum Lesen der in der Speicherzelle (10) gespeicherten Informationen bildet.

6. Speicherzelle (10) nach einem der vorhergehenden Ansprüche, bei welcher das Widerstandsänderungsmaterial (14) ausgestaltet ist, um eine amorphe Phase in einem ersten Zustand zu haben und eine kristalline Phase in wenigstens einem zweiten Zustand zu haben, und bei welcher das Widerstandsänderungsmaterial (14) vorzugsweise ausgewählt ist aus den folgenden Legierungen: Ge2Sb2Te5, GeTe, mit C dotiertes GeTe, mit N dotiertes GeTe, GeSb, GaSb, InGeTe, mit O dotiertes GST.

7. Speicherzelle (10) nach einem der Ansprüche 1 bis 5, bei welcher das Widerstandsänderungsmaterial (14) ein Oxid ist, das aus den folgenden Oxiden ausgewählt ist: Kupferoxid (CuO), Siliziumoxid (SiO2), Hafniumoxid (HfO2), Nickeloxid (NiO), Zinkoxid (ZnO), Aluminiumoxid (Al2O3), Vanadiumoxid (VO2) oder Strontiumtitanatoxid (SrTiO3).

8. Speicherzelle (10) nach einem der vorhergehenden Ansprüche, aufweisend wenigstens drei Speicherzonen (17).

9. Integrierter Schaltkreis mit mehreren Speicherzellen (10) nach einem der vorhergehenden Ansprüche.

10. Integrierter Schaltkreis nach dem vorhergehenden Anspruch, aufweisend wenigstens eine elektronische Basisschaltung (20) an einer Speicherzelle (10) und so ausgestaltet, dass diese Speicherzelle (10) elektrische Pegel liefert, die von wenigstens einer elektronischen Basisschaltung (20) direkt lesbar sind, und bei welchem die Anzahl der Speicherzonen (17), der Widerstand dieser Speicherzonen und die an jeder Versorgungsleitung (V1, V2, .., VN) anliegende Spannung vorzugsweise konfiguriert sind, um die elektrischen Pegel, die von wenigstens einer elektronische Basisschaltung (20) direkt lesbar sind, an die Speicherzelle (10) zu liefern.

11. Integrierter Schaltkreis nach einem der zwei vorhergehenden Ansprüche, bei welchem die Speicherzonen (17) programmiert sind, um zusammen wenigstens einen Spannungsteiler mit wenigstens einem Widerstand zu bilden, dessen Wert hoch genug ist, um den elektronischen Basisschaltungen (20) wenigstens zwei unterschiedliche Spannungspegel nahe den elektrischen Spannungen, die über die unabhängigen Versorgungsleitungen (V1, V2, .., VN) anliegen, zu liefern.

12. Verfahren zur Herstellung einer Speicherzelle (10) nach einem der Ansprüche 1 bis 7 oder eines integrierten Schaltkreises nach einem der Ansprüche 8 bis 11, aufweisend:

    - einen Schritt des Bildens eines Einheitsblocks (34) aus einem Widerstandsänderungsmaterial (14),
    - einen Schritt des In-Kontakt-Bringens des Einheitsblocks (34) des Widerstandsänderungsmaterials (14) mit wenigstens zwei Heizeinrichtungen (16),
    - einen Schritt des Verbindens jeder Heizeinrichtung (16) mit einer Versorgungsleitung (V1, V2, .., VN),
    **dadurch gekennzeichnet, dass** es aufweist:
    - einen Schritt des Realisierens eines Zugangstransistors (30) für die Speicherzelle (10), wobei der Schritt des Realisierens des Transistors (30) einen Schritt bestehend aus einem Bilden eines Kollektors des Transistors (30) mit dem Einheitsblock (34) des Widerstandsänderungsmaterials (14) aufweist.

13. Verfahren nach dem vorhergehenden Anspruch, aufweisend die Schritte des Bildens einer Basis (32) und eines Emitters (36) des Transistors (30), wobei die Schritte des Bildens der Basis (32) und des Emitters (36) Ablagerungen von dotierten Oxiden nacheinander auf die Oberfläche des Einheitsblocks (34) des Widerstandsänderungsmaterials aufweisen.

14. Verfahren nach Anspruch 12, aufweisend die Schritte des Bildens einer Basis (32) und eines Emitters (36) des Transistors (30), in denen die Basis (32) und der Emitter (36) in dem Einheitsblock (34) des Widerstandsänderungsmaterials gebildet und nacheinander durch Dotierung von Bereichen des Einheitsblocks (34) erhalten werden.

15. Verfahren nach einem der drei vorhergehenden Ansprüche, bei welchem die Schritte bei einer Temperatur unter 450°C durchgeführt werden und vorzugsweise nach Abschluss der Realisierung wenigstens einer elektronischen Basisschaltung (20) an der Speicherzelle (10) durchgeführt werden.

**Claims**

1. Non-volatile memory cell (10) comprising at least two separate memory areas (17) each formed from a resistivity-change material (14) able to reversibly change state between at least two stable states having different electrical resistances, the memory cell (10) comprising at least one heating means (16) for each memory area (17), each heating means (16) having at least two ends, one of which is connected to a supply line (V1, V2, ..., VN) and the other one of which is put in contact with the resistivity-change material (14), the resistivity-change material (14) being arranged in a single block (34) common to each of the memory areas (17) of the memory cell (10) so as to create locally each of the separate memory areas (17), **characterised in that** the memory cell (10) comprises an access transistor (30) for programming the memory cell (10), the transistor (30) comprising a collector formed by the single block (34) of resistivity-change material (14).

2. Memory cell (10) according to the preceding claim, wherein the transistor (30) comprises a base (32) and an emitter (36) consisting of metal oxides superimposed on the single block (34) of resistivity-change material (14).

3. Memory cell (10) according to the preceding claim, wherein the materials constituting the base (32) and emitter of the transistor (30) are chosen from the following oxides: p-doped CuO, n-doped IZO, Au-ZnO, Ag-Zno, NiO-IZO, ZRO-ZnO, SCO-ZnO, Poly Si.

4. Memory cell (10) according to claim 1 wherein the transistor comprises a base (32) and an emitter (36), and wherein the base (32) and the emitter (36) are formed in the single block (34) of resistivity-change material (14).

5. Memory cell (10) according to any one of the preceding claims, wherein the single block (34) of resistivity-change material (14) constitutes an output electrode for reading information stored in the memory cell (10).

6. Memory cell (10) according to any one of the preceding claims, wherein the resistivity-change material (14) is conformed so as to have an amorphous phase in a first state and to have a crystalline phase in at least a second state and wherein the resistivity-change material (14) is preferably chosen from the following alloys: Ge2Sb2Te5, GeTe, c-doped GeTe, n-doped GeTe, GeSb, GaSb, InGeTe, O-doped GST.

7. Memory cell (10) according to any one of claims 1 to 5, wherein the resistivity-change material (14) is an oxide chosen from the following oxides: copper oxide ($CuO$), silicon oxide ($SiO_2$), hafnium oxide ($HfO_2$), nickel oxide ($NiO$), zinc oxide ($ZnO$), aluminium oxide or alumina ($Al_2O_3$), vanadium oxide ($VO_2$) or strontium titanium oxide ($SrTiO_3$).

8. Memory cell (10) according to any one of the preceding claims, comprising at least three memory areas (17).

9. Integrated circuit comprising a plurality of memory cells (10) according to any one of the preceding claims.

10. Integrated circuit according to the preceding claim, comprising at least one electronic circuit (20) underlying a memory cell (10) and configured so that said memory cell (10) delivers electrical levels directly readable by the at least one underlying electronic circuit (20) and wherein the number of memory areas (17), the resistance of said memory areas and the voltage applied on each of the supply lines (V1, V2, ..., VN) are preferably configured to deliver electrical levels directly readable by at least one electronic circuit (20) underlying the memory cell (10).

11. Integrated circuit according to any one of the preceding claims, wherein the memory areas (17) are programmed in order together to constitute at least one voltage divider bridge comprising at least one resistor the value of which is sufficiently high to deliver to underlying electronic circuits (20) at least two separate voltage levels close to the electrical voltage applied to the independent supply lines (V1, V2, ..., VN).

12. Method for manufacturing a memory cell (10) according to any one of claims 1 to 7 or an integrated circuit according to any one of claims 8 to 11, comprising:

- a step of forming a single block (34) of resistivity-change material (14);
- a step of putting the single block (34) of resistivity-change material (14) in contact with at least two heating means (16),
- a step of connecting each heating means (16) with a supply line (V1, V2, ..., VN),
**characterised in that** it comprises:
- a step of producing a transistor (30) for access to the memory cell (10), the step of producing the transistor (30) comprising a step consisting of forming a collector of the transistor (30) with the single block (34) of resistivity-change material (14).

13. Method according to the preceding claim, comprising steps of forming a base (32) and an emitter (36) of the transistor (30), the steps of forming the base (32) and emitter (36) comprising depositions of doped oxide successively from the surface of the single block (34) of resistivity-change material.

14. Method according to claim 12, comprising steps of forming a base (32) and an emitter (36) of the transistor (30), wherein the base (32) and the emitter (36) are formed in the single block (34) of resistivity-change material and are obtained successively by doping areas of the single block (34).

15. Method according to any one of the previous three claims, wherein the steps are performed at a temperature below 450 C° and are preferably performed at the end of the production of at least one electronic circuit (20) underlying the memory cell (10).

## Art Antérieur

11  13
Vdd    Vss
12  12
10  14  14
16  16
Sortie  Masse
31
20
21
30

## Figure 1a

Vdd    Vss    Masse
30
31
Commande de
Programmation
11
13
Sortie

## Figure 1b

V₁  V₂  VN

11  13  15

16  16

17  17

10

14  GST

34

Figure 2a

V₁  V₂  VN

33  31

11  13  15

16  16

17  17

10

14  GST  type n

36

n

p

32

Sortie

34  30

20  Circuit Intégré

Figure 2b

V₁  V₂  VN  37  33

30

31

Commande de
Programmation

11  13  15

Sortie

Figure 2c

**Figure 3a**

**Figure 3b**

**Figure 4**

Figure 5a

Figure 5b

Figure 5c

V1 V2 VN

36

32

10

14

CuO

type p

p

n

Sortie

34 30

Circuit Intégré

## Figure 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100259961 A1
- FR 2291609 A1
- US 20030111679 A1
- WO 2010082923 A2
- US 3670220 A, Kun

**Littérature non-brevet citée dans la description**

- **K. YAMAMOTO.** *Surface Science,* 2006, vol. 600, 3753-3756
- **K. B. SONG.** *Applied Physic Letters (APL),* 2008, vol. 93, 043514
- **D. K. SCHRODER.** Semiconductor materials and device characterization. IEEE press, 2006